# EUROPEAN PATENT APPLICATION

(11) **EP 2 308 800 A1**
(43) Date of publication of application: **13.04.2011**
(21) Application number: 09800480.7
(22) Date of filing: 23.07.2009
(51) Int. Cl.: C01B 31/02, C08G 61/12, H01L 31/04

(54) **COMPOSITION, AND ORGANIC PHOTOELECTRIC CONVERSION ELEMENT COMPRISING SAME**

(30) Priority: 24.07.2008 JP 2008190646; 22.09.2008 JP 2008242188
(71) Applicant: Sumitomo Chemical Company, Limited, Tokyo 104-8260 (JP)
(72) Inventor: UETANI, Yasunori, Tsukuba-shi Ibaraki 305-0045 (JP); FUJIWARA, Jun, Ashiya-shi Hyogo 659-0055 (JP)
(74) Representative: Vossius & Partner
(86) International application number: PCT/JP2009/063541
(87) International publication number: WO 2010/010969

(57) **Abstract**

Disclosed is a compos it ion produced by reacting a fullerene derivative with a reducing agent. The composition is preferably produced by adding a reducing agent to a composition comprising a fullerene derivative and a solvent to cause the reaction of the fullerene derivative and the reducing agent. The reducing agent is preferably a trivalent phosphorus compound.

## Description

### TECHNICAL FIELD

The present invention relates to a composition, and an organic photoelectric conversion element using the same.

### BACKGROUND ART

Fullerene derivatives are an organic semiconductor material having a charge (electron, hole) transporting property and expected to be applied to organic photoelectric conversion elements (organic solar cell, optical sensor, etc.) and the like. For example, it is known that a composition containing [6,6]-phenyl-C₇₀-butyric acid methyl ester derivative of C₇₀ fullerene (hereinafter, it may be referred to as [70] PCBM) and chlorobenzene is used for the formation of an organic film included in organic solar cells (without reacting the [70] PCBM with a reducing agent) (Angew. Chem. Int. Ed. 2003, 42, p. 3371-3375).

### DISCLOSURE OF THE INVENTION

However, when the above-mentioned composition is used for the formation of the organic film included in the photoelectric conversion element such as organic solar cells, photoelectric conversion efficiency of the photoelectric conversion element is not necessarily sufficient.

It is an object of the present invention to provide a composition which can provide excellent photoelectric conversion efficiency in being used for the formation of the organic film included in the organic photoelectric conversion element.

First, the present invention provides a composition produced by reacting a fullerene derivative with a reducing agent.

Second, the present invention provides the above-mentioned composition, wherein the composition is produced by adding a reducing agent to a composition comprising a fullerene derivative and a solvent to cause the reaction of the fullerene derivative and the reducing agent.

Third, the present invention provides the above-mentioned composition, wherein the reducing agent is a trivalent phosphorus compound.

Fourth, the present invention provides an organic photoelectric conversion element having an organic layer formed by using the above-mentioned composition.

### BEST MODE FOR CARRYING OUT THE INVENTION

Hereinafter, the present invention will be described in detail.

The composition of the present invention is a composition produced by reacting a fullerene derivative with a reducing agent. Especially, a composition produced by reacting a fullerene derivative with a reducing agent in a solvent is preferable.

The composition of the present invention is more preferably a composition which is produced by adding a reducing agent to a composition comprising a fullerene derivative and a solvent to cause the reaction of the fullerene derivative and the reducing agent.

Examples of the fullerene derivatives used in the present invention include derivatives of C6₀, C₇₀, C₈₄, and carbon nanotube.

Examples of the derivatives of C₆₀ include the following derivatives.

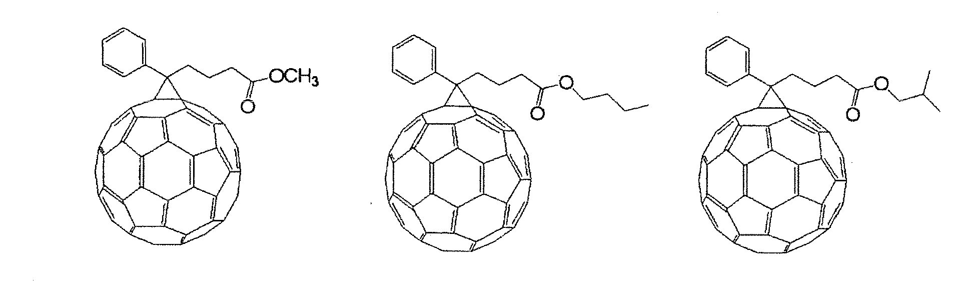

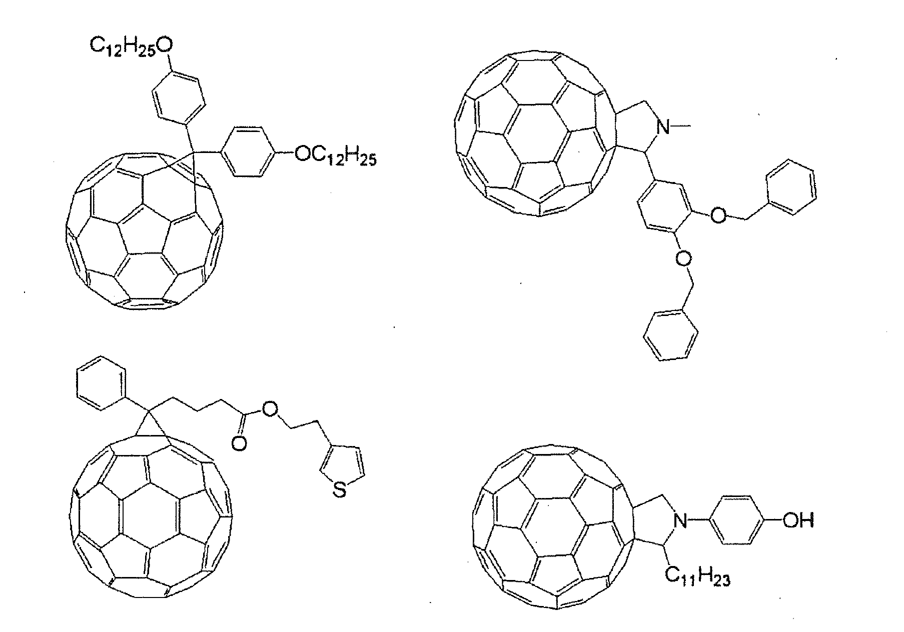

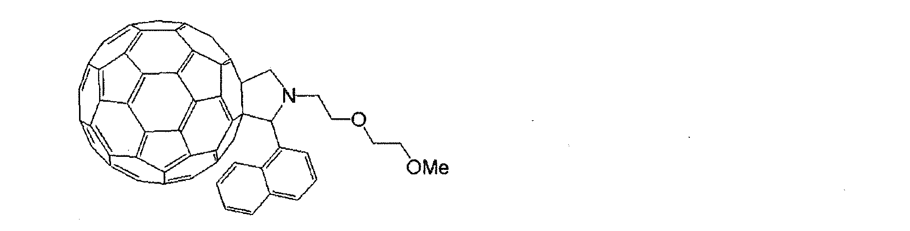

Examples of the derivatives of C₇₀ include the following derivatives.

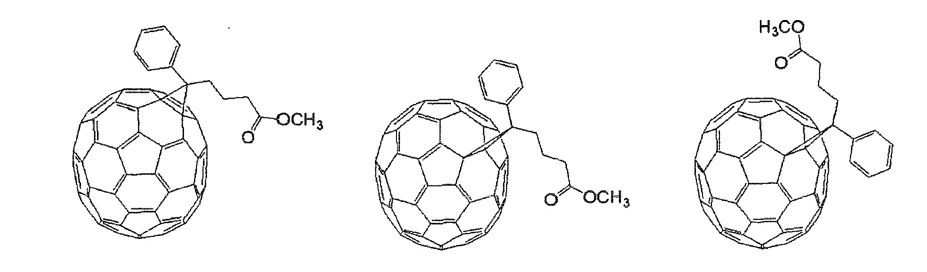

The composition of the present invention is characterized by that the contents of impurities produced as by-products in synthesizing the fullerene derivative are low.

As the reducing agent used in the present invention, a trivalent phosphorus compound is preferable. Examples of the trivalent phosphorus compounds include triarylphosphine, trialkylphosphine, and trialkoxyphosphine. Examples of the triarylphosphine include triphenylphosphine, tri(3-methoxyphenyl)phosphine, and tri(4-methoxyphenyl)phosphine. Examples of the trialkylphosphine include trimethylphosphine, triethylphosphine, tripropylphosphine, tri-n-butylphosphine, and tri-t-butylphosphine. Examples of the trialkoxyphosphine include trimethoxyphosphine, triethoxyphosphine, and tripropoxyphosphine.

As the solvent used for the composition of the present invention, an organic solvent is preferable. Examples of the organic solvent suitably used include solvents in which a fullerene derivative is soluble and which do not react with a reducing agent, for example, the above trivalent phosphorus compound. Examples of the solvents include carbon disulfide, aromatic hydrocarbon, aliphatic hydrocarbon, and chlorinated hydrocarbon. These solvents can be used singly, or can be used as a mixture of two or more solvents mixed in any proportion. Examples of the aromatic hydrocarbon include benzene, toluene, xylene, ethylbenzene, n-propylbenzene, isopropylbenzene, 1,3,5-trimethylbenzene, and 1,2,4-trimethylbenzene. Examples of the aliphatic hydrocarbons include n-pentane, n-hexane, n-heptane, n-octane, n-nonane, n-decane, n-dodecane, n-tetradecane, cyclopentane, cyclohexane, cycloheptane, cyclooctane, and decalin. Examples of the chlorinated hydrocarbons include dichloromethane, chloroform, carbon tetrachloride, 1,2-dichloroethane, chlorobenzene, and dichlorobenzene. A reaction temperature is preferably a temperature in a -10°C and boiling point of the solvent which is used. Further, the reaction is preferably carried out under a nitrogen or argon atmosphere. A reaction time is preferably 30 minutes to 12 hours.

The amount of the reducing agent is usually 1.0 to 5.0 moles, and preferably 1.0 to 3.0 moles with respect to 1 mole of a fullerene derivative.

The weight of the solvent is usually 100 to 500 parts by weight, and preferably 100 to 300 parts by weight with respect to 1 part by weight of a fullerene derivative.

### <Organic Photoelectric Conversion Element>

The organic photoelectric conversion element of the present invention has an organic layer formed by using the composition of the present invention. The organic photoelectric conversion element of the present invention has a pair of electrodes, at least one of which is usually transparent or translucent, and the organic layer formed by using the composition of the present invention between the pair of electrodes.

An operating mechanism of the organic photoelectric conversion element will be described. Light energy passing through the transparent or translucent electrode is absorbed by an electron accepting compound and/or an electron donating compound to produce an exciton in which an electron and a hole are combined into one. When the produced exciton moves and reaches a heterojunction interface where the electron accepting compound and the electron donating compound exist next to each other, the exciton is separated into the electron and the hole due to a difference between HOMO energy and LUMO energy at the interface to generate charges (electron and hole) which can independently move. The generated charges travel respectively to electrodes, and thereby the charges can be externally drawn out as electric energy (electric current).

As an example of the organic photoelectric conversion element of the present invention, either of the following examples:
1. an organic photoelectric conversion element comprising a pair of electrodes, at least one of which is transparent or translucent, a first organic layer (formed by using the composition of the present invention), which is disposed between the electrodes and contains a fullerene derivative as an electron accepting compound, and a second organic layer which is disposed adjacent to the first organic layer and contains an electron donating compound, or
2. an organic photoelectric conversion element comprising a pair of electrodes, at least one of which is transparent or translucent, and at least one organic layer (formed by using the composition of the present invention), which is disposed between the electrodes and contains an electron donating compound and a fullerene derivative as an electron accepting compound, is preferable.

The above-mentioned organic photoelectric conversion element of the paragraph 2 is preferable from the viewpoint of including many heterojunction interfaces.

In the organic photoelectric conversion element of the paragraph 2, a rate of the fullerene derivative in the organic layer containing a fullerene derivative and an electron donating compound is preferably 10 to 1000 parts by weight, and more preferably 50 to 500 parts by weight with respect to 100 parts by weight of the electron donating compound.

The organic layer containing a fullerene derivative, which the organic photoelectric conversion element of the present invention comprises, is preferably formed of an organic thin film containing a fullerene derivative. The thickness of the organic thin film is usually 1 nm to 100 µm, preferably 2 nm to 1000 nm, more preferably 5 nm to 500 nm, and furthermore preferably 20 nm to 200 nm.

The electron donating compound is preferably a polymer compound from the viewpoint of applicability. Examples of the polymer compound include polyvinylcarbazole and derivatives thereof, polysilane and derivatives thereof, polysiloxane derivatives having aromatic amine on the side chain or main chain, polyaniline and derivatives thereof, polythiophene and derivatives thereof, polypyrrole and derivatives thereof, polyphenylenevinylene and derivatives thereof, polythienylenevinylene and derivatives thereof, and polyfluorene and derivatives thereof.

When the fullerene derivative isC70 fullerene derivatives, in order to improve the performance of the organic photoelectric conversion element of the present invention, the amount of the impurities, which has a larger molecular weight than the fullerene derivative in the organic layer by 16, is preferably 5% or less in terms of the area percentage measured at a detection wavelength of 370 nm by HPLC, preferably 1% or less, and more preferably 0 .1% or less with respect to the amount of the fullerene derivative.

When the fullerene derivative is C60 fullerene derivatives, in order to improve the performance of the organic photoelectric conversion element of the present invention, the amount of the impurities, which has a larger molecular weight than the fullerene derivative in the organic layer by 16, is preferably 0.03% or less in terms of the area percentage measured at a detection wavelength of 370 nm by HPLC, and more preferably 0.01% or less with respect to the amount of the fullerene derivative.

The organic photoelectric conversion element of the present invention is generally formed on a substrate. It is preferred that the substrate is not deformed when an electrode or an organic material layer is formed on the substrate. Examples of the materials of the substrate include glass, plastic, polymer film, and silicon.

When the substrate is an opaque substrate, an opposite electrode (that is, an electrode on a side far from the substrate) is preferably a transparent or translucent electrode.

Examples of materials of the transparent or translucent electrode include conductive metal oxide films, and translucent metal thin films. Specifically, films (NESA, etc.) prepared by use of conductive materials comprising indium oxide, zinc oxide, tin oxide and composites thereof, for example, indium tin oxide (ITO) and indium zinc oxide (IZO), or gold, platinum, silver or copper is used, and ITO, indium zinc oxide, and tin oxide are preferable.

Examples of a method for preparing the electrode include a vacuum deposition method, a sputtering method, an ion plating method, and a plating method. As an electrode material, organic transparent conductive films may be used such as polyaniline and derivatives thereof, and polythiophene and derivatives thereof.

As the electrode material, metals or conductive polymers can be further used. A material of one electrode of the pair of electrodes is preferably a material having a small work function. As such materials, metals such as lithium, sodium, potassium, rubidium, cesium, magnesium, calcium, strontium, barium, aluminum, scandium, vanadium, zinc, yttrium, indium, cerium, samarium, europium, terbium or ytterbium, or alloys of two or more thereof; alloys of one or more of the above-mentioned metals and one or more of gold, silver, platinum, copper, manganese, titanium, cobalt, nickel, tungsten and tin; or graphite or graphite interlayer compounds are used. Examples of the alloys include magnesium-silver alloy, magnesium-indium alloy, magnesium-aluminum alloy, indium-silver alloy, lithium-aluminum alloy, lithium-magnesium alloy, lithium-indium alloy, and calcium-aluminum alloy.

In the organic photoelectric conversion element of the present invention, an additional layer may be disposed between at least one electrode and the organic layer containing a fullerene derivative, used in the present invention. Examples of the additional layers include a charge transport layer which transports a hole or an electron, and a buffer layer. Examples of materials used for the charge transport layer to transport a hole or an electron as the additional 1 layer include the following.

Examples of compounds used as the charge transport layer to transport a hole include phthalocyanine, metal phthalocyanines, porphyrin, metal porphyrins, oligothiophene, tetracene, pentacene, rubrene, polyvinylcarbazole and derivatives thereof, polysilane and derivatives thereof, polysiloxane derivatives having aromatic amine on the side chain or main chain, polyaniline and derivatives thereof, polythiophene and derivatives thereof, polypyrrole and derivatives thereof, polyphenylenevinylene and derivatives thereof, polythienylenevinylene and derivatives thereof, and polyfluorene and derivatives thereof.

Examples of compounds used as the charge transport layer to transport an electron include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complex of 8-hydroxyquinoline and derivatives thereof, polyquinoline and derivatives thereof, polyquinoxaline and derivatives thereof, polyfluorene and derivatives thereof, and phenanthrene such as 2,9-dimethyl-4,7-diphenyl-1,10-phenanthroline.

As the materials used as the buffer layer as an additional layer, alkali metal such as lithium fluoride, halide and oxide of alkaline-earth metals can be used. Further, fine particles of inorganic semiconductor such as titanium oxide can also be used.

### <Production Method of Organic Layer>

The photoelectric conversion element of the present invention has an organic layer formed by using the composition of the present invention.

When the organic layer is formed by using the composition of the present invention, the organic layer is preferably produced after the reducing agent is partially or wholly, preferably substantially wholly, removed. Examples of methods of removing the reducing agent include a method in which the reducing agent is removed from the composition by use of column chromatography and a method in which the fullerene derivative is drawn out from the composition by reprecipitation.

When the composition of the present invention is a composition produced by reacting a fullerene derivative with a reducing agent in a solvent, examples of a method of forming an organic layer by use of the composition of the present invention include the following methods of paragraphs (a), (a-1), (b) and (b-1), and the methods of the paragraphs (a-1) and (b-1) are preferable.
(a) Method of forming an organic layer by applying the compos it ion of the present invention.
   (a-1) Method of forming an organic layer by applying a solution prepared by removing the reducing agent from the composition of the present invention.
(b) Method of forming an organic layer by applying a solution prepared by removing the solvent from the composition of the present invention, and adding a solvent suitable for an application method.
   (b-1) Method of forming an organic layer by applying a solution prepared by removing the solvent and the reducing agent from the composition of the present invention, and adding a solvent suitable for an application method.

Examples of the solvent suitable for an application method include hydrocarbon solvents such as toluene, xylene, mesitylene, tetralin, decalin, bicyclohexyl, n-butylbenzene, s-butylbenzene and t-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane; halogenated unsaturated hydrocarbon solvents such as chlorobenzene, dichlorobenzene and trichlorobenzene; and ether solvents such as tetrahydrofuran and tetrahydropyran. The above-mentioned fullerene derivatives can be generally dissolved in the above solvent in an amount of 0.1% by weight or more.

The above-mentioned solution may further contain a polymer compound. Specific examples of solvents to be used for the solution include the above-mentioned solvents, but aromatic hydrocarbon solvents are preferable, and toluene, xylene, and mesitylene are more preferable from the viewpoint of the solubility of polymer compounds. Further, halogenated unsaturated hydrocarbon solvents are preferable, and chlorobenzene and o-dichlorobenzene are more preferable from the viewpoint of the solubility of fullerene derivatives.

In order to form an organic layer from a solution, applicationmethods, such as spin coatingmethod, castingmethod, microgravure coating method, gravure coating method, bar coating method, roll coating method, wire bar coating method, dip coating method, spray coating method, screen printing method, flexo printingmethod, off set printing method, inkjetprintingmethod, dispenser printing method, nozzle coating method and capillary coating method, can be used, and spin coating method, flexo printing method, ink jet printing method, and dispenser printing method are preferably used.

The organic photoelectric conversion element of the present invention can be operated as an organic thin film solar cell since a photovoltaic power is generated between electrodes by being irradiated from a transparent or translucent electrode with light such as solar light. The organic photoelectric conversion element of the present invention can also be used as an organic thin film solar cell module by integrating a plurality of organic thin film solar cells.

The organic photoelectric conversion element of the present invention can be operated as an organic optical sensor since a photocurrent flows by being irradiated from a transparent or translucent electrode with light in a state of applying a voltage between the electrodes. The organic photoelectric conversion element of the present invention can also be used as an organic image sensor by integrating a plurality of organic optical sensors.

### EXAMPLES

Hereinafter, examples will be described to explain the present invention in more detail, but the present invention is not limited to these examples.

Impurities contained in the C70PCBM were measured by analysis of LC-MS. As the LC/MS, an LC/MS apparatus (Agilent 1100) manufactured by Agilent Technologies Japan, Ltd. , in which a diode array detector (detection wavelength 370 nm) and a mass spectrometry detector (provided with an atmospheric pressure chemical ionization interface) were incorporated, was used, and to this, L-Column ODS (4.6 mm × 25 mm, particle diameter 3 µm, manufactured by Chemicals Evaluation and Research Institute, Japan) as a column was connected. Methanol to which ammonium acetate was added so as to be 50 mM in concentration as a mobile-phase, and toluene were passed through the column at a flow rate of 1.0 ml/min while changing a ratio of toluene from 20% to 80% in 60 minutes, and a sample was dissolved in toluene so as to be 0.1% in concentration and injected.

In the following Examples, a number average molecular weight and a weight average molecular weight of the polymer compound on the polystyrene equivalent basis were determined byGPC (PL-GPC2000) manufactured by GPC Laboratory. The polymer compound was dissolved in o-dichlorobenzene so as to be about 1% by weight in concentration. As the mobile-phase of GPC, o-dichlorobenzene was used and o-dichlorobenzene was passed at a flow rate of 1 ml/min at a measuring temperature of 140°C. As a column, three PLGEL 10 µm MIXED-Bs (manufactured by PL Laboratory) are connected in series.

### Synthesis Example 1

### (Synthesis of Polymer Compound 1)

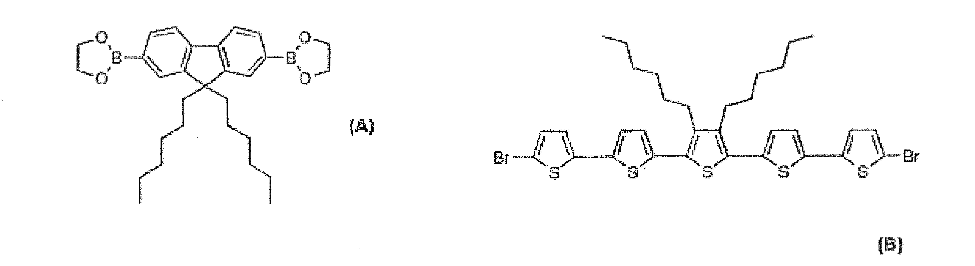

7.928 g (16.72 mmol) of the compound (A), 13.00 g (17.60 mmol) of the compound (B), 4.979 g of methyltrioctylammonium chloride (trade name: "Aliquat 336" (trademark), manufactured by Aldrich Chemical Company, Inc., CH₃N[(CH₂)₇CH₃]₃Cl, density 0.884 g/ml at 25°C), and 405 ml of toluene were put in a 2 liter four-necked flask, the inside of which was replaced with an argon gas, and the inside of a system was bubbled for 30 minutes with an argon gas while being stirred. 0.02 g of dichlorobis(triphenylphosphine)palladium(II)was added, and to the resulting mixture, 42.2 ml of a 2 mol/L aqueous solution of sodium carbonate was added dropwise while heating at 105°C and stirring the mixture.
After adding dropwise, the mixture was reacted for 5 hours, and 2.6 g of phenylboronic acid and 1.8 ml of toluene were added and the resulting mixture was stirred at 105°C for 16 hours. 700 ml of toluene and 200 ml of a 7.5% aqueous solution of sodium diethyldithiocarbamate trihydrate were added and the resulting mixture was stirred at 85°C for 3 hours. A water layer was removed and then the other portion was washed with 300 ml of ion-exchanged water of 60°C twice, with 300 ml of a 3% acetic acid solution of 60°C once, and with 300 ml of ion-exchanged water of 60°C three times. An organic layer was passed through a column filled with cerite, alumina and silica, and the column was cleaned with 800 ml of hot toluene. A solution was concentrated to 700 ml and then added to 2 liter of methanol by injection to be reprecipitated. A polymer was recovered by filtration and washed with 500 ml of methanol, 500 ml of acetone and 500 ml of methanol. The polymer was dried under a vacuum at 50°C for one night to obtain 12.21 g of pentathienyl-fluorene copolymer (hereinafter, referred to as a "polymer compound 1") represented by the following formula: 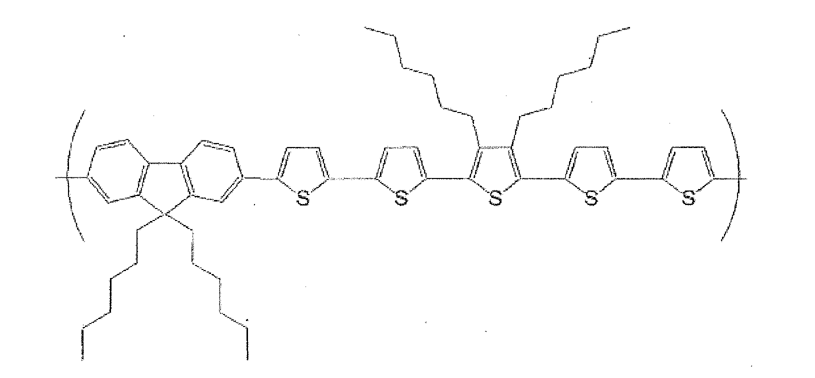 A number average molecular weight of the polymer compound 1 was 5.4 ×10⁴ on the polystyrene equivalent basis and a weight average molecular weight was 1.1 × 10⁵.

### Synthesis Example 2

### (Synthesis of Compound C)

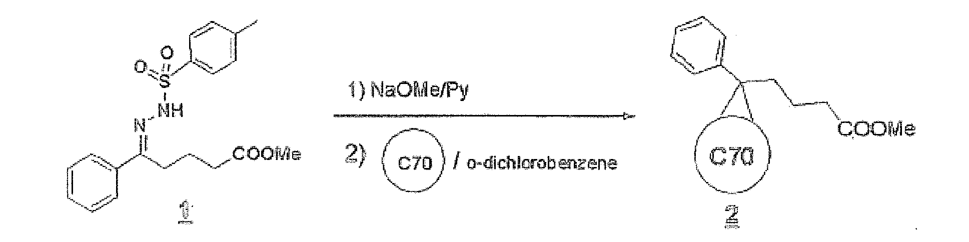

Under a nitrogen atmosphere, 0.5 ml of pyridine and 0.27 g (0.72 mmol) of hydrazone compound 1 were charged into a 100 ml recovery flask and the resulting mixture was stirred with a mechanical stirrer at room temperature and dissolved. To this, 0.05g (0.93 mmol) of sodiummethoxide was added, and the resulting mixture was stirred for 15 minutes. To this, a solution prepared by dissolving 0.3 g (0.36 mmol) of C70 in 50 ml of 1,2-dichlorobenzene was added, and the resulting mixture was heated and stirred at 70°C for 24 hours. Thereafter, the reaction mixture cooled to room temperature was purified through a silica gel chromatography (300 g of WakosilC-300 was used, eluent was toluene) and the purified solution was condensed to 100 ml under a reduced pressure and then it was refluxed while being heated for 12 hours. The reaction mixture was cooled, and then purified again through a silica gel column chromatography (300 g of WakosilC-300 was used, eluent was toluene) and the purified solution was condensed to 50 ml under a reduced pressure. To the condensed solution, 100 ml of methanol was added, and a precipitate produced was separated by filtration and washed with 20 ml of hexane twice and with 20 ml of diethyl ether twice, and then dried under a reduced pressure of 50 torr at 80°C for 5 hours to obtain 0.08 g (yield 18.3%) of [70] PCBM 2. The PCBM is referred to as a compound C. The compound C was analyzed by high performance liquid chromatography (HPLC) (LC-10A (manufactured by Shimadzu Corp.), column used: L-Column ODS (4.6 mm × 25 cm manufactured by Chemicals Evaluation and Research Institute, Japan, film pressure 3 µm), detection wavelength: 370 nm, flow rate: 1 ml/minute, gradient method (solution A: 50mM ammonium acetate/methanol, solution B: toluene, solution B 20%-40 minutes-60%)), and consequently the purity of the [70] PCBM of an objective compound was 93.6% (a percentage of a peak area of an objective component in a total peak area of chromatogram (area percentage), total value of three types of isomers), and 5.39% (area percentage) of impurities were detected.

Impurities contained in the compound C were measure by an analysis of LC-MS, and it was verified that values of molecular ion peaks (M+) of impurities (three types of isomers) are larger than the value of M+ of the [70]PCBM by 16. These impurities are thought to be a monoxide of the [70]PCBM.

### Example 1

### (Production of a Composition 1)

### (Compound D (Synthesis of [70] PCBM in which oxide is reduced))

Under a nitrogen atmosphere, 0.07 g (0.06 mmol) of the compound C synthesized in Synthesis Example 2 described above, which is a fullerene derivative, and 20 ml of mesitylene of a solvent were charged into a 50 ml recovery flask, and further 0.07 g (0.27 mmol) of triphenylphosphine was added and the resulting mixture was heated and stirred at 150°C for 12 hours in the nitrogen gas flow. The reaction mixture was cooled, and then purified through a silica gel column chromatography (100 g of WakosilC-300 was used, eluent was toluene) to produce a composition 1. The composition 1 was condensed to 10 ml under a reduced pressure, and to this, 10 ml of methanol was added, and a precipitate produced was separated by filtration and triphenylphosphine was removed. Thereafter, the precipitate was washed with 10 ml of hexane twice and with 10 ml of diethyl ether twice, and then dried under a reduced pressure of 50 torr at 80°C for 5 hours to obtain 0.06 g (yield 85.7%) of [70]PCBM. The PCBM is referred to as a compound D.

The compound D was analyzed in the conditions of HPLC described in Synthesis Example 2 described above, and consequently the purity of the [70] PCBM of an objective compound was 98.9% (area percentage, total value of three types of isomers), and the content of the impurities was reduced to 0.58% (area percentage) .

### Synthesis Example 3

### Synthesis of Compound E

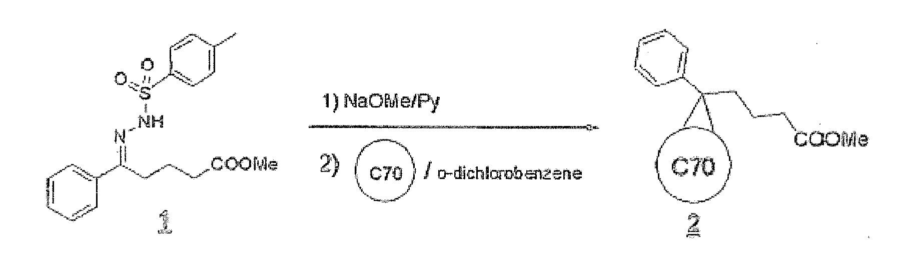

Under a nitrogen atmosphere, 0.5 ml of pyridine and 0.27 g (0.72 mmol) of hydrazone compound 1 were charged into a 100 ml eggplant flask and the resulting mixture was stirred with a mechanical stirrer at roomtemperature and dissolved. To this, 0.05 g (0.93 mmol) of sodiummethoxide was added, and the resulting mixture was stirred for 15 minutes. To this, a solution prepared by dissolving 0.3 g (0.36 mmol) of C70 in 50 ml of 1,2-dichlorobenzene was added, and the resulting mixture was heated and stirred at 70°C for 24 hours. The reaction mixture cooled to room temperature after overheating was purifed through a silica gel chromatography (300 g of WakosilC-300 was used, eluent was toluene) and the purified solution was condensed to 100 ml under a reduced pressure and then it was refluxed while being heated for 12 hours. The reaction mixture was cooled, and then purified again through a silica gel column chromatography (300 g of WakosilC-300 was used, eluent was toluene) and the purified solution was condensed to 50 ml under are reduced pressure. To the condensed solution, 100 ml of methanol was added, and a precipitate produced was separated by filtration and washed with 20 ml of hexane twice and with 20 ml of diethyl ether twice, and then dried under a reduced pressure of 50 torr at 80°C for 5 hours to obtain 0.12 g (yield 16.1%) of [70]PCBM 2. The PCBM is referred to as a compound E. The compound E was analyzed by high performance liquid chromatography (HPLC) (column used: L-Column ODS (4.6 mm × 25 cm manufactured by Chemicals Evaluation and Research Institute, Japan, film pressure 3 µm), detection wavelength: 370 nm, flow rate: 1 ml/minute, gradient method (solution A: 50 mM ammonium acetate/methanol, solution B: toluene, solution B 20%-40 minutes-60%)), and consequently the purity of the [70] PCBM of an objective compound was 97.1% (area percentage, total value of three types of isomers), and 2.69% (area percentage) of components estimated to be impurities were detected.

### Example 2

### (Production of a Composition 2)

### (Compound F (Synthesis of [70] PCBM in which oxide is reduced))

Under a nitrogen atmosphere, 0.10 g (0.10 mmol) of the compound E synthesized in Synthesis Example described above and 20 ml of 1, 2, 4-trimethylbenzene were charged into a 50 ml recovery flask, and further 0.04g (0.20 mmol) of tributylphosphine was added and the resulting mixture was stirred at room temperature for 4 hours in the nitrogen gas flow. The reaction mixture was cooled, and then purified through a silica gel column chromatography (200 g of WakosilC-300 was used, eluent was toluene) to obtain a composition 2. The composition 2 was condensed to 10 ml under a reduced pressure, and to this, 10 ml of methanol was added, and a precipitate producedwas separated by filtration and tributylphosphine was removed. The precipitate was washed with 10 ml of hexane twice and with 10 ml of diethyl ether twice, and then dried under a reduced pressure of 50 torr at 80°C for 5 hours to obtain 0.09 g (yield 90.0%) of C70PCBM. The PCBM is referred to as a compound F. The compound F was analyzed in the conditions of HPLC described in Synthesis Example 3 described above, and consequently the purity of the [70]PCBM of an objective compound was 99.8% (area percentage, total value of three types of isomers), and components estimated to be impurities were not detected.

### Example 3

### (Preparation and Evaluation of Organic Thin Film Solar Cell)

The polymer compound 1 as an electron donator was dissolved in o-dichlorobenzene at a concentration of 0.5% by weight. Thereafter, the compound D as an electron acceptor was mixed in the resulting solution in an amount three times larger than that of the electron donator. Next, the solution was filtered using a Teflon (trademark) filter with pore size of 0.2 µm to prepare an application solution.

A glass substrate provided with an ITO film of 150 nm in thickness by a sputtering method was surface-treated by an ozone UV treatment. Next, the above-mentioned application solution was applied by spin coating to obtain an active layer (film thickness about 100 nm) of the organic thin film solar cell. Thereafter, the active layer was dried in a vacuum at room temperature for 60 minutes.
Then, lithium fluoride was deposited in a thickness of 4 nm by a vacuum vapor deposition machine, and then aluminum was deposited in a thickness of 100 nm to fabricate an organic thin film solar cell being a photoelectric conversion element. A degree of vacuum at the time of vapor deposition was always 1 × 10⁻³ to 9 × 10⁻³ Pa. The shape of the obtained organic thin film solar cell was a square having a size of 2 mm × 2 mm. The obtained organic thin film solar cell was irradiated with a certain amount of light using a solar simulator (trade name OTENTO-SUNII manufactured by BUNKOUKEIKI Co., Ltd.: AM 1.5G Filter, irradiance 100 mW/cm²), and a current and a voltage generated were measured to determine photoelectric conversion efficiency. The results of measurements are shown in Table 1.

### Example 4

### (Preparation and Evaluation of Organic Thin Film Solar Cell)

A photoelectric conversion element was prepared in the same manner as in Example 3 except for using the compound F in place of the compound D and photoelectric conversion efficiency of the element was determined. The measurement results are shown in Table 1.

### Comparative Example 1

### (Preparation and Evaluation of Organic Thin Film Solar Cell)

A photoelectric conversion element was prepared in the same manner as in Example 3 except for using the compound C in place of the compound D and photoelectric conversion efficiency of the element was determined. The measurement results are shown in Table 1.

### Example 5

### (Production of a Composition 3)

### (Compound G (Synthesis of [60] PCBM in which oxide is reduced))

[60]PCBM ([6,6]-phenyl-C₆₀-butyric acid methyl ester derivative of C₆₀ fullerene) (E100 manufactured by Frontier Carbon Corp.: Lot no. 8A0125-A) was analyzed in the conditions of HPLC described in Synthesis Example 3 described above, and consequently the purity of the [60] PCBM of an objective compound was 99.0%, and 0.37% (area percentage) of components estimated to be impurities were contained. 0.04% (area percentage) of components estimated to be impurities was oxide of the [60] PCBM. Under a nitrogen atmosphere, 0.42 g (0.46 mmol) of the [60] PCBM (E100 manufactured by Frontier Carbon Corp.: Lot no. 8A0125-A) and 80 ml of 1,2,4-trimethylbenzene were charged into a 100 ml recovery flask, and further 0.19 g (0.92 mmol) of tributylphosphine was added and the resultingmixture was stirred at room temperature for 4 hours in the nitrogen gas flow. The reaction mixture was cooled, and then purified through a silica gel column chromatography (300 g of WakosilC-300 was used, eluent was toluene). After the resulting fraction was condensed to 30 ml under a reduced pressure, 20 ml of methanol was added, and a precipitate produced was separated by filtration, washed with 20 ml of hexane twice and with 20 ml of diethyl ether twice, and then dried under a reduced pressure of 50 torr at 80°C for 5 hours to obtain 0.34 g (yield 81.0%) of a compound G. The compound G was analyzed in the conditions of HPLC described in Synthesis Example 3 described above, and consequently the purity of the compound G of an objective compound was 99.3% and components estimated to be impurities were not detected.

### Example 6

### (Preparation and Evaluation of Organic Thin Film Solar Cell)

A photoelectric conversion element was prepared in the same manner as in Example 3 except for using the compound G in place of the compound D and photoelectric conversion efficiency of the element was determined. The measurement results are shown in Table 1.

### Comparative Example 2

### (Preparation and Evaluation of Organic Thin Film Solar Cell)

A photoelectric conversion element was prepared in the same manner as in Example 3 except for using the [60] PCBM (E100 manufactured by Frontier Carbon Corp. : Lot no. 8A0125-A) in place of the compound D and photoelectric conversion efficiency of the element was determined. The measurement results are shown in Table 1.

**Table 1**

| | Fullerene derivative | Photoelectric conversion efficiency (%) |
|---|---|---|
| Example 3 | Compound D | 2.3 |
| Example 4 | Compound F | 4.1 |
| Comparative Example 1 | Compound C | 1.9 |
| Example 6 | Compound G | 3.2 |
| Comparative Example 2 | [60]PCBM | 2.7 |

### -Evaluation-

As is evident from Table 1, the organic photoelectric conversion elements, which are prepared by using the composition produced by adding a reducing agent to a composition comprising a fullerene derivative and a solvent to cause the reaction of the fullerene derivative and the reducing agent, and then removing the reducing agent, exhibited higher photoelectric conversion efficiency than the organic photoelectric conversion elements prepared without using the composition.

### Industrial Applicability

The present invention is extremely industrially useful since by employing the composition of the present invention, a photoelectric conversion element exhibiting excellent photoelectric conversion efficiency can be fabricated.

## Claims

1. A composition produced by reacting a fullerene derivative with a reducing agent.

2. The composition according to claim 1, wherein said composition is produced by adding a reducing agent to a composition comprising a fullerene derivative and a solvent to cause the reaction of the fullerene derivative and the reducing agent.

3. The composition according to claim 1 or 2, wherein the reducing agent is a trivalent phosphorus compound.

4. An organic photoelectric conversion element having an organic layer formed by using the composition according to any one of claims 1 to 3.
